# EUROPEAN PATENT SPECIFICATION

(11) **EP 0 926 733 B1**
(45) Date of publication and mention of the grant of the patent: **17.03.2004**
(21) Application number: 97830677.7
(22) Date of filing: 16.12.1997
(51) Int. Cl.: H01L 23/40, H01L 23/367

(54) **Card assembly of power device in plastic package with external heat sink soldered to the internal heat sink**
Leiterplattenanordnung bestehend aus einem in einem Kunststoffgehäuse verpackten Leistungshalbleiterbauelement, dessen interne Wärmesenke mit einer externen Wärmesenke gelötet ist
Ensemble formant une carte comprenant un dispositif de puissance dans un boitier en plastique avec un dissipateur thermique externe soudé au dissipateur thermique interne

(43) Date of publication of application: 30.06.1999
(73) Proprietor: STMicroelectronics S.r.l., 20041 Agrate Brianza (Milano) (IT)
(72) Inventor: Tiziani, Roberto, 20014 Nerviano (IT); Rossi, Roberto, 20058 Villasanta (IT); Villa, Claudio Maria, 20058 Villasanta (IT)
(74) Representative: Pellegri, Alberto

(56) References cited:
- EP-A- 0 533 067
- US-A- 4 340 902
- US-A- 4 924 352
- US-A- 5 272 599
- PATENT ABSTRACTS OF JAPAN vol. 006, no. 211 (E-137), 23 October 1982 & JP 57 117263 A (MITSUBISHI DENKI KK), 21 July 1982,
- PATENT ABSTRACTS OF JAPAN vol. 011, no. 292 (E-543), 19 September 1987 & JP 62 092347 A (MITSUBISHI ELECTRIC CORP), 27 April 1987,
- PATENT ABSTRACTS OF JAPAN vol. 008, no. 139 (E-253), 28 June 1984 & JP 59 047750 A (HITACHI SEISAKUSHO KK), 17 March 1984,
- BOND, G.L. ET AL: "Wrap-Around Heat Sink" IBM TECHNICAL DISCLOSURE BULLETIN., vol. 20, no. 4, September 1977, NEW YORK US, pages 1434-1435, XP002063836
- PATENT ABSTRACTS OF JAPAN vol. 018, no. 299 (E-1558), 8 June 1994 & JP 06 061635 A (ROHM CO LTD), 4 March 1994,
- "Technique for Heat-Sinking to Lower K" IBM TECHNICAL DISCLOSURE BULLETIN., vol. 4, no. 10, March 1962, NEW YORK US, page 53 XP002063837

## Description

The present invention relates to techniques of dissipation of the heat generated inside integrated devices encapsulated in a plastic package for assembly, on the surface of a printed circuit board.

The problem of dissipating the heat generated within the integrated circuit and to maintain the internal temperature of a package, typically of plastic material, below a maximum tolerable value, is particularly relevant when assembling power devices packages on the surface of a printed circuit board.

According to a typical geometry of many power device packages for surface mounting on printed circuit boards, that is of packages wherein the body of resin partially encapsulates a metal heat sink usually of copper on whose surface is mounted the silicon dice and which acts as an internal heat sink, the presence of the metal heat sink on the bottom face of the integrated device, makes it impossible to install an external heat sink simply resting on the device mounted on the card because of the relatively poor thermal coupling that may be realized.

Therefore, in order to increase heat dissipation during operation, several approaches are known.

A first approach is that of patterning copper pad on the printed circuit onto which the internal heat sink of the power device package is soldered. In this manner the heat generated inside the device may be effectively transferred to the external world through the copper pad exploiting a spreading effect over the printed circuit board.

Often, a plurality of holes are realized within the copper pad. These holes have their inner wall covered with a film of copper and constitute as many conductive vias for transferring heat across the thickness of the board to the other side of it where another dedicated copper pad may be patterned, on which an external metal sink may be placed or alternately contacted by the metal chassis of the apparatus.

According to a similar approach, the metal coated holes do not cross the whole thickness of the board but reach a ground metallization layer sandwiched therein, typically in the form of a copper film, perfectly suitable to disperse the heat throughout the board.

Another known solution consists of printed circuit boards specially realized on a relatively thick metal substrate of a thermally conductive material such as aluminum.

Another prior art heat sink assembly is described in the publication "Wrap-around Heat Sink" by Bond et al., IBM Technical Disclosure Bulletin vol. 70, no. 4 (1977), p. 1434-1435.

All these known solutions imply the use of specially configured printed circuit boards or the use of printed circuit boards having special composite structures apt to favor heat dissipation. Therefore, these known solutions are rather costly and often require special printed circuit board that may not be compatible with attendant requisites of a particular manufacturer of apparatuses.

Vis-à-vis this state of the art, it has now been found a system for soldering an external metal heat sink that may be installed on the power device assembled of the printed circuit board, and which may be soldered to the internal heat sink of the power device, despite of its location customarily on the bottom side of the device (slug down) surface mounted on the printed circuit board.

Therefore, according to the invention it is possible to solder an external heat sink placed over the power device to the internal heat sink of the package during a normal soldering operation of all the devices and components installed on the printed circuit board that conveniently may have a normal structure, that is, without specially designed characteristics for favoring dissipation of the heat generated in the power devices having an internal metal heat sink placed at the bottom of their package that is on the assembling side (slug down).

The system of the invention applies to any power device wherein the metal slug (internal metal heat sink) of the power device package has at least a portion projecting out of the surface of at least one side of the package commonly a molded body of encapsulating resin.

An external metal heat sink, having a shape suited to couple with the particular package of the power device surface-mounted on a printed circuit board, has at least a surface bearing on the package in a manner as to leave a gap between the protruding part of the metal heat sink incorporated in the package and a surface spacingly opposed to it of the external metal heat sink. The gap being readily encroached and filled by the molten eutectic tin/lead alloy during a normal soldering step of the devices and components installed on a printed circuit board.

According to a first embodiment of the invention, the internal metal slug has a portion that extends from the plane of the bottom encapsulating resin body of the power device package. The external metal heat sink has a base that is substantially shaped as a flat frame, whose dimensions are coordinated with the package dimensions so that the protruding part of the metal slug of the package remains contained in the aperture of the bottom frame portion of the external heat sink, on the sides of which bear the recessed perimetral part of the bottom of the molded body of encapsulating resin of the package that surrounds the protruding part of the metal slug.

In this manner a gap remains between the outer perimetral surface of the metal slug and the inner perimetral surface of the bottom flat frame of the external metal heat sink which may be filled at least partially by molten soldering eutectic alloy of a patterned layer of soldering paste preventively applied on the assembly areas of the devices and components.

Upon solidification of the solder alloy between the inner perimeter of the projecting part of the metal slug of the package and the inner surface of the aperture of the flat frame of the external metal heat sink, an effective thermally conducting bridge is realized that favors heat transfer from the metal slug to the external heat sink.

According to an alternative embodiment of the invention, the internal heat sink protrudes from two opposed sides of the molded body of resin of the power device package, at the bottom of the latter, that rests on the patterned layer of soldering paste defined on the component assembly side of the board. The external metal heat sink is shaped so to be placed over the power device. The external metal heat sink has two legs that extend toward the surface of the printed circuit board along the above mentioned sides of the package, and which bear on the printed layer of soldering paste, thus defining a gap between each laterally extending part of the metal slug and the inner face side of the relative vertical leg of the external metal sink opposed to it.

Such a small vertical gap is at least partially encroached by the liquefied eutectic alloy during the soldering phase thus soldering permanently each of the two laterally protruding parts of the internal metal slug to the opposed leg of the external heat sink placed over the device.

The various aspects and advantages of the invention will become even clearer through the following description of several embodiments and by referring to the annexed drawings, wherein:
**Figure 1** is a perspective view of a power device with an internal metal slug protruding from the bottom side of the molded body of encapsulating resin;
**Figure 2** is a perspective view of an external metal heat sink designed, according to the present invention, for coupling with the device of Fig. 1;
**Figures 3** to **7** are a full, a detail and a sectional view of an assembly made according to the present invention;
**Figure 8** is a perspective view of a power package realized according to a different embodiment of the invention;
**Figure 8b** is an enlarged detail of Fig. 8.
**Figure 9** is a perspective view of an external metal heat sink for mounting on the device of Fig. 8, according to the present invention.
**Figures 10** to **13** are a full, a detail and a sectional view of an assembly made according to the present invention.

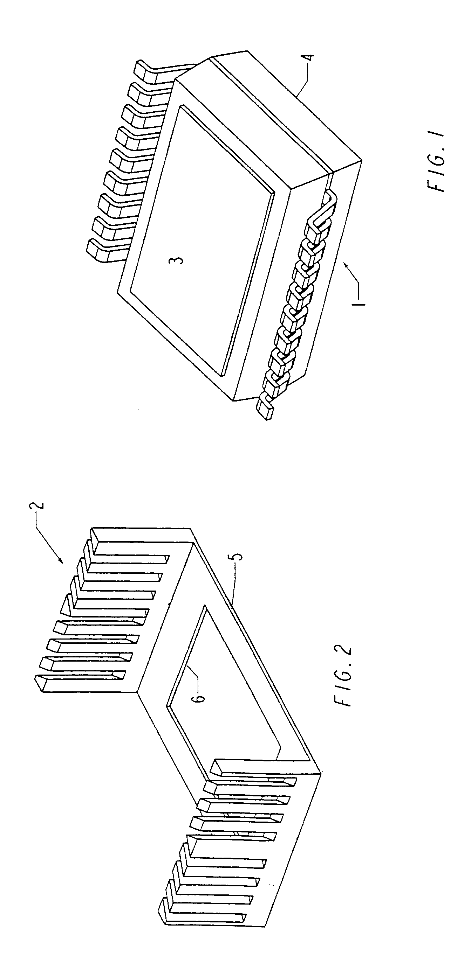

Figures 1 to 7 refer to a first embodiment of the invention. The same parts and features are identified with the same numbers in the different figures.

An essential requisite of a power package 1 that may be provided with an external metal heat sink 2, according to the invention, is that an internal metal heat sink (or simply slug) 3, commonly of a highly conducting metal such as copper or nickel coated copper, onto which is bonded the silicon chip or dice of the integrated circuit, is only partially buried in the molded body of the encapsulating resin and protrudes for a certain height from the bottom face of the device 1, commonly configured for surface-assembly on a printed circuit board 7.

As shown in Fig. 2, the external metal heat sink 2 has a substantially flat base shaped as a rectangular frame 5, the dimensions of the central aperture 6 of the frame being coordinated with the dimensions of the protruding part of the internal metal slug 3 of the power package 1, so to accommodate such a protruding part in the aperture 6.

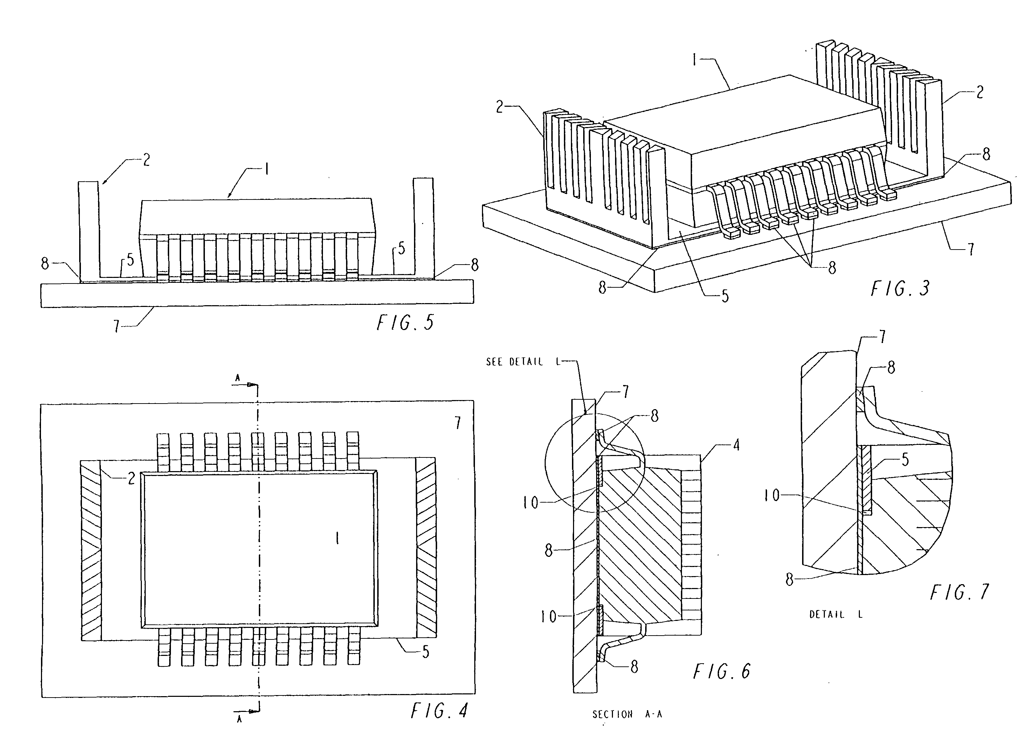

As shown in Figures 3 to 7 of the assembly of the invention, the device 1 is positioned on the printed circuit board 7 after having positioned thereon the external metal heat sink 2 so that the recessed perimetral part of the bottom side surrounding the protruding metal slug 3 may rest on the four sides of the flat frame 5, whose thickness may be approximately identical to the height of the protruding part of the metal slug 3 emerging out of the bottom side of the molded resin body 4. They may both rest on the patterned layer of soldering paste 8 preventively screen printed on the surface of the board 7.

During the soldering step, the molten eutectic alloy 8 tends to fill at least partially, the gap 10, finally soldering the internal metal slug 3 to the flat frame 5 of the external metal heat sink.

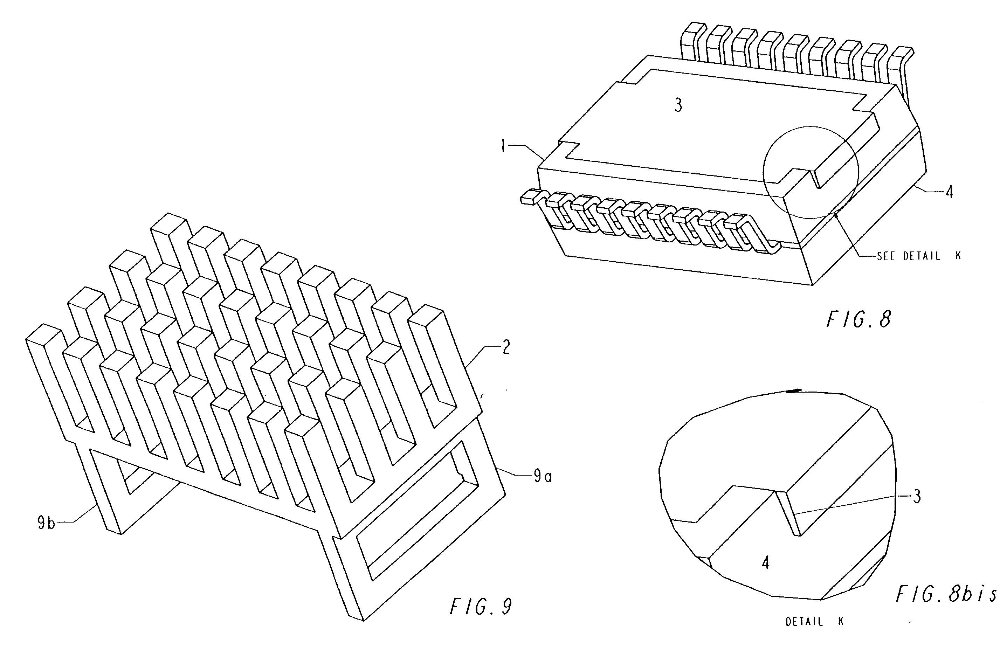

An alternative embodiment of the invention is illustrated in Figures 8 to 13.

According to this alternative embodiment, the metal heat sink 3 protrudes laterally out of two opposed sides of the encapsulating resin body 4 of the device 1.

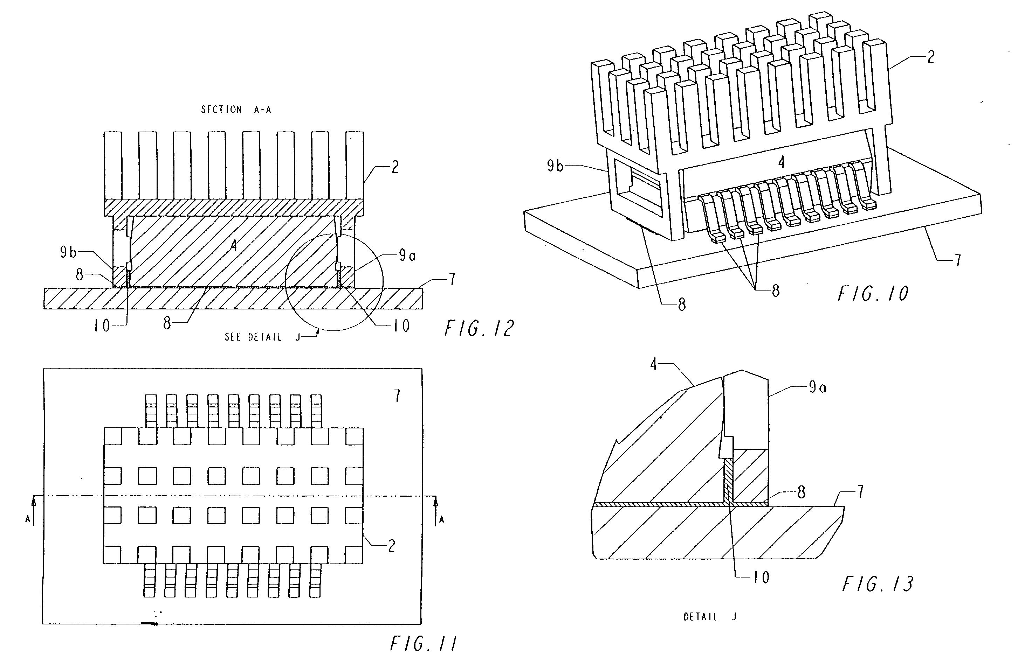

In this case the specially designed external metal heat sink 2, shown in Fig. 9, to be mounted on the device 1 and has two lateral legs or wings 9a and 9b that extend towards the surface of the card 7 and their ends bear on the patterned layer of solder paste preventively screen printed on the face of the card 7, according to common techniques.

As shown in the section of Fig. 12 and even better in the enlarged view of Fig. 13, during the heat treatment for melting the soldering paste 8, the gap 10 between each laterally protruding part of the internal metal slug 3 and the opposed inner surface of the respective leg (9a, 9b) of the external metal heat sink 2 is encroached by the molten solder alloy eventually soldering the two parts together and establishing an effective heat conducting path from the internal metal slug 3 to the external metal heat sink 2 placed on the device 1.

The system of the invention permits to realize assemblies that include an external metal heat sink that can be mounted on power devices surface mounted on the printed circuit board, notwithstanding the fact that the power devices be of the so-called "slug-down" type.

## Claims

1. An assembly of an external heat sink (2) soldered to a metal slug (3) incorporated at the bottom of a molded body (4) of encapsulating resin of the package of an integrated power device surface mounted on a surface of a printed circuit board (7), **characterized in that**
said metal slug (3) has at least a portion protruding from an outer surface of at least one face of said body (4);
said external metal heat sink (2) is placed on said surface of the printed circuit board (7) and has a first and a second portion, whereby at least said first portion (5, 9a, 9b) rests on said surface of the printed circuit board (7) and has at least a surface abutting with a surface of said body (4) such that a separation gap (10) is defined between at least a surface of said protruding portion of the metal slug (3) and a surface of said first portion (5, 9a, 9b) opposed to it, said separation gap being filled with a solder alloy (8).

2. The assembly of claim 1,further **characterized in that** said metal slug (3) protrudes from the bottom side of said resin body (4), over a portion of area of the bottom of the resin body and said first portion of the external metal heat sink (2) comprises a substantially flat base frame (5) of a size such that said protruding part of the metal slug (3) of the package fits into an aperture (6) of said flat base frame (5), over which abuts a recessed perimetral portion of the bottom of the resin body (4) surrounding said protruding part (3), leaving said gap (10) between an outer perimetral surface of the protruding part of the metal slug (3) and an inner perimetral part of said aperture (6) said gap being filled by the solder alloy (8).

3. The assembly of claim 1, further **characterized in that** said metal slug (3) protrudes from two opposite lateral faces of said resin body (4) and said external metal heat sink (2) has a shape suitable for said second portion of the external heat sink (2) being placed on the device and said first portion of the external heat sink (2) comprises two legs (9a, 9b) extending towards the surface of the printed circuit board (7) along said two lateral faces of said resin body (4) and defining said separation gap (10) between each protruding part of said metal slug (3) and the inner surface of the respective leg (9a, 9b) opposed to it, said gap being filled by the solder alloy (8).

## Patentansprüche

1. Anordnung einer externen Wärmesenke (2), welche an einen Metallrohling (3) gelötet ist, der im Boden eines Gusskörpers (4) aus einem die Packung eines integrierten Leistungsgeräts einkapselnden Harz eingebaut ist, welcher auf einer Oberfläche einer gedruckten Leiterplatte (7) montiert ist, **dadurch gekennzeichnet, dass**
der Metallrohling (3) wenigstens einen Abschnitt aufweist, der von einer äußeren Oberfläche von wenigstens einer Seite des Körpers (4) vorspringt;
die externe Metallwärmesenke (2) auf der Oberfläche der gedruckten Leiterplatte (7) platziert ist und einen ersten und einen zweiten Abschnitt aufweist, wobei wenigstens der erste Abschnitt (5, 9a, 9b) auf der Oberfläche der gedruckten Leiterplatte (7) ruht und wenigstens eine Oberfläche aufweist, die an eine Oberfläche des Körpers (4) stößt, derart, dass eine Trennungslücke (10) zwischen wenigstens einer Oberfläche des Vorsprungsabschnitts des Metallrohlings (3) und einer dieser entgegengesetzten Oberfläche des ersten Abschnitts (5, 9a, 9b) definiert ist, wobei die Trennungslücke mit einer Lötlegierung (8) gefüllt ist.

2. Anordnung nach Anspruch 1, ferner **dadurch gekennzeichnet, dass** der Metallrohling (3) von der Bodenseite des Harzkörpers (4) vorspringt und über einem Flächenabschnitt des Bodens des Harzkörpers der erste Abschnitt der externen Metallwärmesenke (2) einen im wesentlichen flachen Basisrahmen (5) umfasst, mit einer solchen Größe, dass der vorspringende Teil des Metallrohlings (3) der Packung in eine Öffnung (6) des flachen Basisrahmens (5) passt, worüber ein den vorspringenden Teil (3) umgebender, ausgesparter Umfangsabschnitt des Bodens des Harzkörpers (4) anstößt, wobei die Lücke (10) zwischen einer äußeren Umfangsfläche des vorspringenden Teils des Metallrohlings und einem inneren Umfangsteil der Öffnung (6) freigelassen wird, wobei die Lücke von der Lötlegierung (8) gefüllt ist.

3. Anordnung nach Anspruch 1, welche ferner **dadurch gekennzeichnet ist, dass** der Metallrohling (3) von zwei gegenüberliegenden Seitenflächen des Harzkörpers (4) vorspringt und die externe Metallwärmesenke (2) eine Gestalt hat, die geeignet ist, dass der zweite Abschnitt der externen Wärmesenke (2) auf dem Gerät platziert wird, und wobei der erste Abschnitt der externen Wärmesenke (2) zwei Schenkel (9a, 9b) umfasst, die zur Oberfläche der gedruckten Leiterplatte (7) längs zweier seitlicher Flächen des Harzkörpers (4) ragen und die Trennungslücke (10) zwischen jedem vorspringenden Teil des Metallrohlings (3) und der diesem entgegengesetzten Innenfläche des jeweiligen Schenkels (9a, 9b) definiert, wobei die Lücke mit der Lötlegierung (8) gefüllt ist.

## Revendications

1. Montage d'un radiateur externe (2) soudé à une pièce métallique (3) incorporée au fond d'un corps moulé (4) de résine d'encapsulation du boîtier d'un dispositif de puissance intégré monté en surface sur la surface d'une carte de circuit imprimé (7), **caractérisé en ce que** :
la pièce métallique (3) comporte au moins une partie faisant saillie à partir d'une surface externe d'au moins une face du corps (4) ;
le radiateur métallique externe (2) est placé sur la surface de la carte de circuit imprimé (7) et comporte une première et une seconde partie, de sorte qu'au moins la première partie (5, 9a, 9b) repose sur la surface de la carte de circuit imprimé (7) et a au moins une surface en butée avec une surface du corps (4) de sorte qu'un intervalle de séparation (10) est défini entre au moins une surface de la partie en saillie de la pièce métallique (3) et une surface de la première partie (5, 9a, 9b) qui lui est opposée, l'intervalle de séparation étant rempli d'un alliage de soudure (8).

2. Montage selon la revendication 1, **caractérisé en outre en ce que** la pièce métallique (3) fait saillie à partir du côté inférieur du corps de résine (4) sur une partie de la surface du fond du corps de résine et la première partie du radiateur métallique externe (2) comprend un châssis de base sensiblement plat (5) d'une dimension telle que la partie en saillie de la pièce métallique (3) du boîtier s'adapte dans une ouverture (6) du châssis de base plat (5) sur lequel bute une partie périphérique évidée du fond du corps de résine (4) entourant la partie en saillie (3), en laissant ledit intervalle (10) entre une surface périphérique externe de la partie en saillie de la pièce métallique (3) et une partie périphérique interne de l'ouverture (6), l'intervalle étant rempli de l'alliage de soudure (8).

3. Montage selon la revendication 1, **caractérisé en outre en ce que** la pièce métallique (3) fait saillie à partir de deux faces latérales opposées du corps de résine (4) et le radiateur métallique externe (2) a une forme convenable pour que la seconde partie du radiateur externe (2) soit placée sur le dispositif et **en ce que** la première partie du radiateur externe comprend deux pattes (9a, 9b) s'étendant vers la surface de la carte de circuit imprimé (7) le long des deux faces latérales du corps de résine (4) et définissant ledit intervalle de séparation (10) entre chaque partie en saillie de la pièce métallique (3) et la surface interne de la patte respective (9a, 9b) qui lui est opposée, l'intervalle étant rempli de l'alliage de soudure (8).
